# EUROPEAN PATENT SPECIFICATION

(11) **EP 4 513 753 B1**
(45) Date of publication and mention of the grant of the patent: **11.11.2026**
(21) Application number: 24169170.8
(22) Date of filing: 09.04.2024
(51) Int. Cl.: H03F 1/32, H03F 3/195, H03F 3/24

(54) **APPARATUS AND METHOD FOR DIGITAL PREDISTORTION INITIALIZATION OF HIGH-POWER AMPLIFIERS**
VORRICHTUNG UND VERFAHREN ZUR INITIALISIERUNG DER DIGITALEN VORVERZERRUNG VON HOCHLEISTUNGSVERSTÄRKERN
APPAREIL ET PROCÉDÉ D'INITIALISATION DE PRÉDISTORSION NUMÉRIQUE D'AMPLIFICATEURS DE HAUTE PUISSANCE

(30) Priority: 25.08.2023 US 202318238011
(43) Date of publication of application: 26.02.2025
(73) Proprietor: L3Harris Technologies, Inc., Melbourne, FL 32919 (US)
(72) Inventor: LARAWAY, Stephen A., Melbourne, 32919 (US); BERRY, Brent J., Melbourne, 32919 (US)
(74) Representative: Schmidt, Steffen J.

(56) References cited:
- US-B2- 9 160 310
- HYUNCHUL KU ED - ANONYMOUS: "Closed-form expression of IMD considering input/output frequency responses in nonlinear RF power amplifiers for digital predistortion", MICROWAVE CONFERENCE, 2006. APMC 2006. ASIA-PACIFIC, IEEE, PI, 1 December 2006 (2006-12-01), pages 425 - 428, XP031201514, ISBN: 978-4-902339-08-6, DOI: 10.1109/APMC.2006.4429454

## Description

### BACKGROUND

High-power amplifiers (HPAs) may exhibit a nonlinear response (e.g., due to saturation). Examples for power amplifiers exhibiting a nonlinear response are disclosed in HYUNCHUL KU ED - ANONYMOUS: "Closed-form expression of IMD considering input/output frequency responses in nonlinear RF power amplifiers for digital predistortion", MICROWAVE CONFERENCE, 2006. APMC 2006. ASIA-PACIFIC, IEEE, 1 December 2006 (2006-12-01), pages 425-428.
As the input power to the HPA increases, the HPA moves from a linear region of operation and into saturation region. In the saturation region, the output signal from the HPA becomes compressed, exhibiting less and less gain as the input power to the HPA increases. This nonlinear response of the HPA distorts transmit signals, resulting in intermodulation distortion (IMD) and harmonic distortion that can degrade the performance of a radio frequency (RF) transmitter, for example. Accordingly, when HPAs are operated in their nonlinear region, their output becomes distorted. The distortion can affect the in-band performance and may also result in interference in adjacent channels.

Although digital predistortion (DPD) may be used to pre-compensate for the nonlinear response of the HPA, there are several challenges to determine/initialize the filter coefficients of the DPD. These challenges are further compounded for wideband applications and applications with strong nonlinearities. For example, the filter coefficients are often not linearly applied to compensate for distortion. When using previous approaches the filter coefficients cannot be solved for using a linear method such as a least-squares. Additionally, when using previous approaches, the initialization of the DPD tends not to be robust to a wide variety of different waveforms with different characteristics and to a wide range of frequencies and bandwidths. Further, previous approaches tend to fail for strong nonlinearities.

The subject matter claimed herein is not limited to examples that solve any disadvantages or that operate only in environments such as those described above. Rather, this background is only provided to illustrate one exemplary technology area where some examples described herein may be practiced.

### BRIEF SUMMARY

The invention is defined by independent claim 1. Further embodiments are defined by the dependent claims.

One example illustrated herein is a given apparatus or method provided for digital predistortion of an electrical signal to pre-compensate for nonlinear distortions in a nonlinear channel (e.g., a nonlinear channel including a high-power amplifier). The digital predistortion processor includes a nonlinear filter. Filter coefficients are determined using a modified input electrical signal having multiple simultaneous tones, using an iterative process which adapts the modified input electrical signal to reduce levels of intermodulation distortions in a modified output electrical signal. This Summary is not intended to identify key features or essential features of the claimed subject matter, nor is it intended to be used as an aid in determining the scope of the claimed subject matter.

Additional features and advantages will be set forth in the description which follows, and in part will be obvious from the description, or may be learned by the practice of the teachings herein. Features and advantages of the invention may be realized and obtained by means of the instruments and combinations particularly pointed out in the appended claims. Features of the present invention will become more fully apparent from the following description and appended claims, or may be learned by the practice of the invention as set forth hereinafter.

### BRIEF DESCRIPTION OF THE DRAWINGS

In order to describe the manner in which the above-recited and other advantages and features can be obtained, a more particular description of the subject matter briefly described above will be rendered by reference to specific examples which are illustrated in the appended drawings. Understanding that these drawings depict only typical examples and are not therefore to be considered to be limiting in scope, examples will be described and explained with additional specificity and detail through the use of the accompanying drawings in which:
Figure 1 illustrates a block diagram of a transmitter, according to one example;
Figure 2A illustrates a plot of a response curve for an amplifier, according to one example;
Figure 2B illustrates a plot of a gain curve for an amplifier, according to one example;
Figure 3A illustrates a block diagram of a nonlinear channel, according to one example;
Figure 3B illustrates a block diagram of a digital predistortion (DPD) architecture for a channel having nonlinear distortions with memory, according to one example;
Figure 4 illustrates a block diagram of memory polynomial, according to one example;
Figure 5 illustrates a block diagram showing which distortions are corrected by which distortion correction blocks, according to one example;
Figure 6 illustrates a block diagram of a DPD architecture for a channel having nonlinear distortions without memory, according to one example;
Figure 7A illustrates a flow diagram of an initialization method, according to one example;
Figure 7B illustrates a flow diagram of a process for initializing a linear filter, according to one example;
Figure 7C illustrates a flow diagram of a process for calculating an ideal nonlinear correction output, according to one example;
Figure 7D illustrates a flow diagram of a process for calculating coefficients of a memory polynomial, according to one example;
Figure 8 illustrates a block diagram of a nonlinear channel having a third-order nonlinear distortion, according to one example;
Figure 9 illustrates a plot of frequency pairs for a set of multi-tone signals, according to one example;
Figure 10 illustrates a pulse sequence of a multi-tone signal, according to one example;
Figure 11 illustrates a block diagram of an adaptive intermodulation distortion cancelation process to determine ideal nonlinear correction output, according to one example;
Figure 12A illustrates a block diagram of using a DPD architecture to pre-compensate for linear and nonlinear channel distortions, according to one example;
Figure 12B illustrates a block diagram of using an alternative DPD architecture to pre-compensate for nonlinear channel distortions, according to one example; and
Figure 13 illustrates another block diagram of a transmitter, according to one example.

### DETAILED DESCRIPTION

Previous methods of determining the DPD coefficients were not capable of correcting for strong RF distortions (linear and nonlinear) across wide bandwidths while being waveform agnostic. Some examples described herein address these challenges.

As discussed above, previous approaches to initializing digital predistortion (DPD) processors suffer from various challenges, especially for wideband applications and high-power amplifiers (HPA) with strong nonlinearities.

Nonlinear Signal distortions are due to linear and nonlinear effects of an RF chain, including a high-power amplifier (HPA). The output power versus input power of the HPA can be (and usually is) a nonlinear function. In a memoryless HPA the output power is a function of the input power at the current time. Memoryless nonlinearities can be described by an AM/AM curve and AM/PM curve. In an HPA that has memory, the HPA gain depends on the input signal at the current time and at times in the past. In addition to nonlinear distortion with memory effects, an HPA may have significant linear distortions before and after the nonlinearity.

Memory effects may result from energy storage in the system and are also a manifestation of the dynamical behavior of the system. As an example of how memory influences the output of a power, the rise and fall times of an amplifier may be different in the amplifier, resulting in a different output voltage for the same input voltage, depending on whether the current voltage is on a rising edge or a falling edge of the input signal. This phenomenon is known as hysteresis.

In previous DPD systems, the goal was typically limited to compensating for a single consistent signal type within a narrow bandwidth. Some examples described herein go farther, in that the DPD and initialization algorithms are capable of wide bandwidth operation while being waveform agnostic, which could include different modulations, different bandwidths, different carrier frequencies, and different number of signals. This signal environment presents several challenges not encountered when only compensating for a single consistent signal type within a narrow bandwidth. First, using adaptation alone to initially find the DPD coefficients has been used previously when compensating for a single consistent signal type within a narrow bandwidth. For the more demanding cases (e.g., multiple frequencies, wide bandwidths, multiple signals, and/or multiple modulations protocols), however, adaptation alone is insufficient to initially find the DPD coefficients. Second, in contrast to the previous DPD systems, the current DPD system can advantageously function properly for many signal types over the full system band.

Some examples described herein address the above-mentioned challenges using, e.g., a multi-step method in which the problem to be solved at each step is linear-in-parameters, and/or using a multi-tone sounding method that ensures robust corrections for a wide range of frequencies and wide variety of different waveforms, as well as being robust for strong nonlinearities.

Some examples described herein use DPD to pre-compensate for distortions arising from a linear and/or nonlinear channel (e.g., electrical components in a radio frequency (RF) and/or microwave transmitter). For example, high power amplifiers (HPAs) may have linear, and/or nonlinear memory effects particularly when operating near compression. These effects cause spectral distortions, namely intermodulation distortions (IMD) and harmonic distortions. These undesired artifacts may interfere with other users in the band. One approach to avoid these distortions in the transmitted output is to merely avoid the nonlinear regions of the HPA by reducing the signal input. But this has the unwanted consequence of decreasing the output power. Instead, the approach adopted here uses digital predistortion (DPD) to maintain a high output power with low IMD and harmonic levels.

Some examples described herein have the benefits of determining a DPD that is adapted to the linear, nonlinear, and memory characteristics of the entire RF chain, including the HPA and the other parts of the RF chain that are causing the linear, nonlinear, and memory effects. Further, some examples described herein are sufficiently robust to cover many waveform types, a wide bandwidth, and cover simultaneous signals for a system with significant distortions.

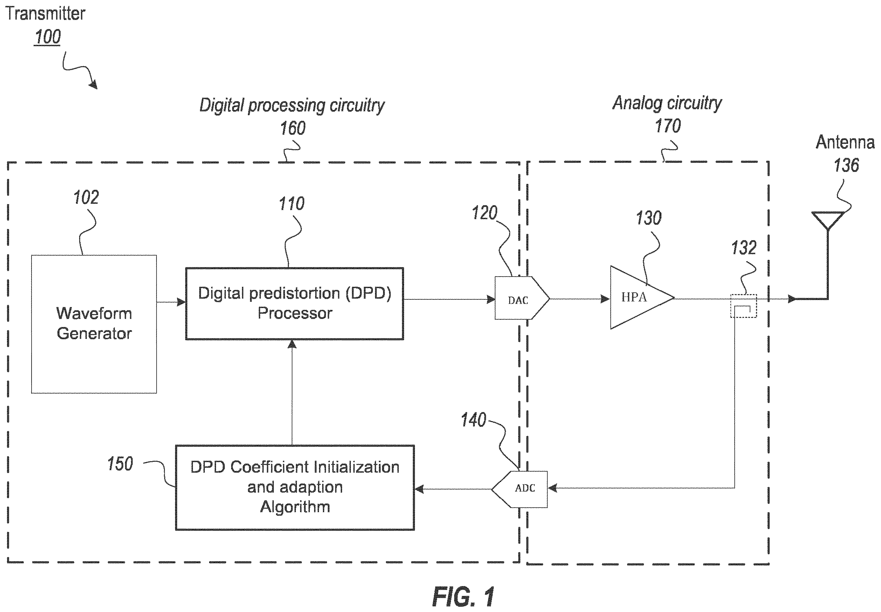

Referring now to FIG. 1, a transmitter 100 is shown (e.g., the transmitter 100 can be a radio frequency (RF), microwave, or millimeter wave transmitter). Within the digital processing circuitry 160, the transmitter 100 includes a waveform generator 102 that transmits a digital waveform to the DPD processor 110. Next, the signal is converted to analog by a digital-to-analog converter (DAC) 120, resulting in an analog signal, which demarks a transition from the digital processing circuitry 160 to the analog circuitry 170. The resultant analog signal is then amplified by the HPA 130. Note that this is a simplified representation, and that in practice there are often many analog and RF components that may add linear distortion to the signal. A portion of the output from the HPA 130 is sampled at the coupled port 132, and the sampled signal from the coupled port 132 is converted back to digital via an analog-to-digital converter (ADC) 140. The resultant digital signal is fed to processing circuitry 150 that performs a DPD coefficient initialization and adaption method to generate the coefficients used in DPD processor 110. The DPD processor 110 compensates for nonlinear and linear distortions resulting from the HPA 130 and other/accompanying circuitry in the transmission path to the antenna 136.

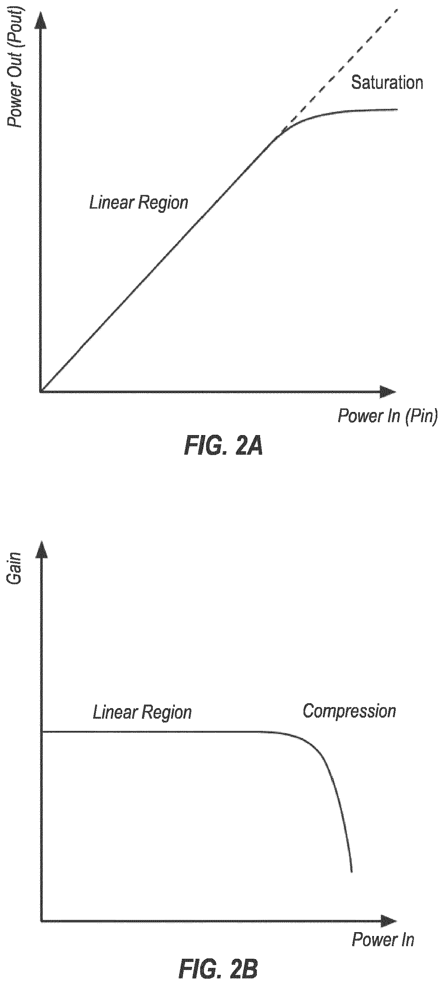

FIGs. 2A and 2B illustrate nonlinear distortions for a memoryless HPA model. In FIG. 2A, an example plot is provided showing the power out (Pₒᵤₜ) of the HPA 130 as a function of the power in (Pᵢₙ). In the linear region (e.g., for low Pᵢₙ), the Pₒᵤₜ changes essentially linearly as a function of the Pᵢₙ. But, for higher values of Pᵢₙ, the Pₒᵤₜ rolls over, e.g., due to saturation of the HPA 130.

FIG. 2B illustrates an example plot of the gain as a function of the Pᵢₙ. Here, the gain is constant throughout the linear region (e.g., for low Pᵢₙ), and, as Pᵢₙ increases into the saturation region, the gain decreases, which decreases is referred to as compression. The power drive-up characteristic and gain response shown respectively in FIGs. 2A and 2B are common for an RF power amplifier at the fundamental frequency of operation. At low powers, the amplifier is in the linear region of operation. In practice, RF and microwave HPAs deviate from the ideal, and, even in a small-signal, linear regime, the amplifier is unlikely to be completely linear. This may be because the physical mechanisms governing charge control in the FET (field effect transistor) channel or the base of a BJT (bipolar junction transistor) are not themselves perfectly linear functions. Thus, even at low power, the HPA 130 will generate some low level of distortion.

At higher powers, the output power and gain deviate significantly from the linear relationship at small signal. This is the compression region of operation. At sufficiently high input drive, the Pₒᵤₜ flattens. At this point, the power has been saturated. In these regions of operation, the HPA 130 is very nonlinear. This compression behavior is also known as AM-to-AM conversion: by modulating (changing) the input signal amplitude, the amplitude of the output signal is modulated in a nonlinear fashion.

The onset of this 'strong' nonlinearity may be indicated by the 1-dB gain compression point (i.e., the output power at which the gain is one decibel below the small-signal value). When the HPA is at 1-dB compression, the output signal is already being distorted.

Some examples described herein use digital predistortion (DPD) before the HPA 130 to compensate for the nonlinear response of the HPA 130 and to reduce intermodulation distortion (IMD) and harmonic distortion. As discussed above, high power amplifiers (HPAs) are generally nonlinear devices when driven at higher input powers, especially for powers close to or exceeding the 1-dB gain compression point. This nonlinearity of the HPA 130 distorts transmit signals, causing IMD and harmonic distortion, which can degrade the performance of RF transmitters. Preferably, the DPD processor 110 applies an inverse nonlinear function to the transmit signal so that the output of the HPA 130 is an undistorted signal. As discussed above, FIG. 1 illustrates a schematic diagram for an example of a transmitter 100 using DPD. The DPD processor 110 is applied during digital processing (i.e., before the signal is converted from digital to analog via the digital-to-analog converter (DAC) 120), and a coupled port 132 samples data at the output of the HPA 130 that is used for initialization of the DPD coefficients.

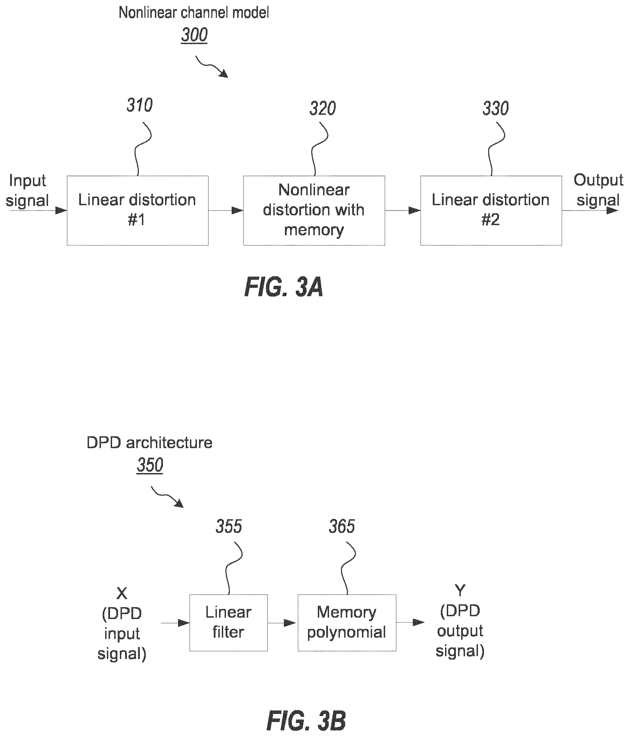

FIG. 3A shows a block diagram of a nonlinear channel model 300 including three blocks. This nonlinear channel model 300 may be used for development of DPD architecture. According to the three-block model 300, the linear distortion blocks 310 and 330 represent linear amplitude and phase distortions, and the nonlinear distortion block 320 represents nonlinear amplitude and phase distortions including, e.g., distortions with memory effects.

FIG. 3B shows a block diagram of a proposed DPD architecture 350, illustrating details of one example of the DPD processor 110 illustrated in Figure 1. The two main processing blocks are a linear filter 355 and a memory polynomial 365. The linear filter 355 and memory polynomial 365 may have complex coefficients. In some examples, interpolation is applied before the memory polynomial 365 to avoid aliasing.

In certain non-limiting examples, the memory polynomial block 365 can compensate for nonlinear memory effects resulting from thermal variation and bias circuits, for example. The memory polynomial model 365 includes a delay line and polynomial function. The signal is input to the polynomial function which calculates certain terms. Next, the signal passes through the delay line. Outputs are then summed. The total number of taps in the delay line defines the memory depth of the model. The memory polynomial may include even terms and higher order terms (for example, 2^{nd} order terms or 7^{th} order terms).

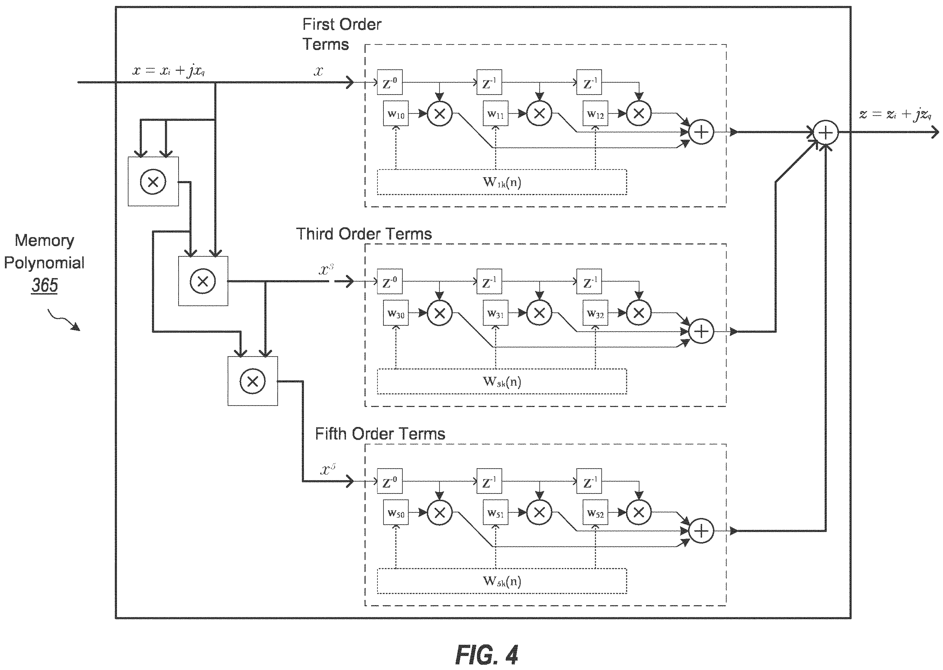

FIG. 4 illustrates an example of a memory polynomial 365. In this example, the memory polynomial includes 1^{st}, 3^{rd}, and 5^{th} order nonlinear terms. These nonlinear terms expand the signal bandwidth. Because of this bandwidth expansion, interpolation (upsampling) may need to be applied before the memory polynomial to avoid aliasing.

The memory polynomial 365 can invert a channel that has linear distortion followed by nonlinear distortion (i.e., a Wiener system), but it is not able to invert a channel that has linear→nonlinear→linear (i.e., a Wiener-Hammerstein system). The Wiener-Hammerstein system includes linear filters before and after a static nonlinearity. The Wiener-Hammerstein system is a good model/approximation to a power amplifier, such as HPA 130. The two linear filters in a Wiener-Hammerstein system can represent/model the input and output matching networks to the amplifier and linear distortion from other analog/RF components, and the amplifier is represented by the nonlinearity

Because the memory polynomial can invert a linear→nonlinear system-but not a linear→nonlinear→linear system-the linear filter 355 is incorporated into the DPD architecture 350, such that the DPD architecture 350 can invert a linear→nonlinear→linear system. That is, the memory polynomial cannot by itself correct for the linear distortion #2 in block 330 of FIG. 3A. However, the DPD architecture 350 in FIG. 3B includes the linear filter 355 before the memory polynomial 365 to cancel out linear distortion #2.

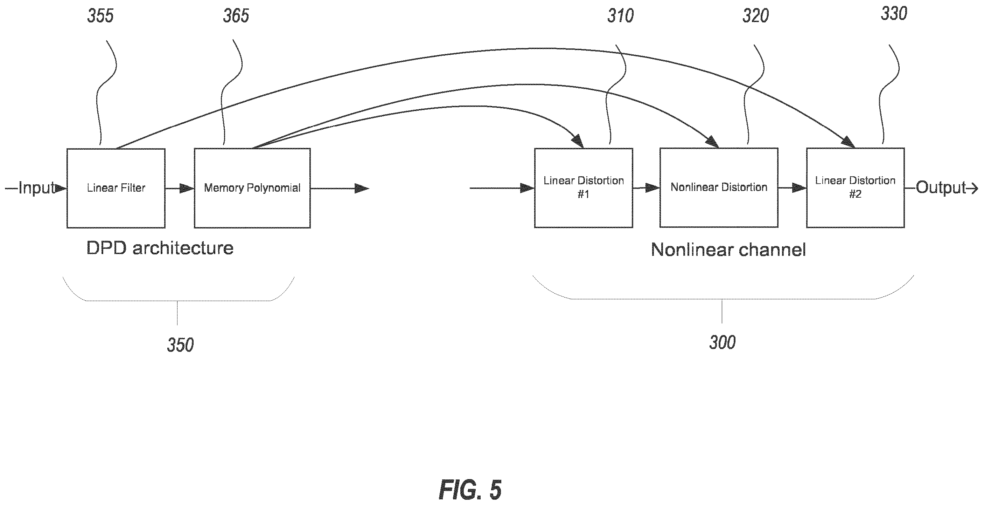

FIG. 5 combines the nonlinear channel model 300 with the DPD architecture 350, FIG. 5 and shows (using the curved upper arrows) which blocks in the DPD architecture 350 correct which distortions in the nonlinear channel model 300. That is, the DPD linear filter 355 inverts the channel model linear distortion #2 of block 330, and the DPD memory polynomial 365 inverts the channel model linear #1 of block 310 and the nonlinear distortion of block 320.

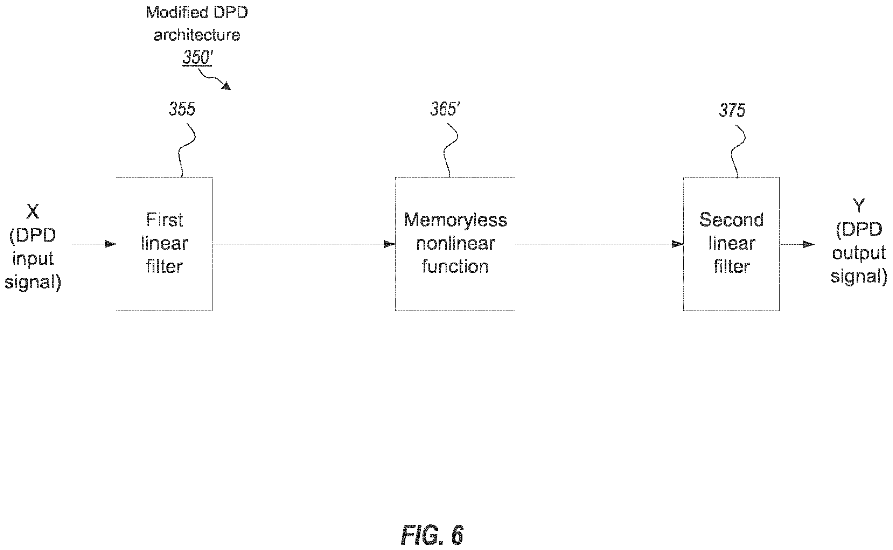

The DPD architecture 350 can handle nonlinear memory effects. If the HPA 130 does not have significant nonlinear memory effects (i.e., the nonlinearity can be accurately modeled with AM/AM and AM/PM curves), then the memory polynomial 365 can be replaced by a memoryless nonlinearity 365' and a complex linear filter 375, as shown in the modified DPD architecture 350', which is illustrated in FIG. 6.

FIG. 6 shows a block diagram of a modified DPD architecture 350'. The three main processing blocks are a first linear filter 355, a memoryless nonlinear function 365', and a second linear filter 375. The benefit of the memoryless architecture in the modified DPD architecture 350' is that the memoryless architecture has significantly lower complexity and reduced computational burden relative to the memory polynomial architecture in the DPD architecture 350.

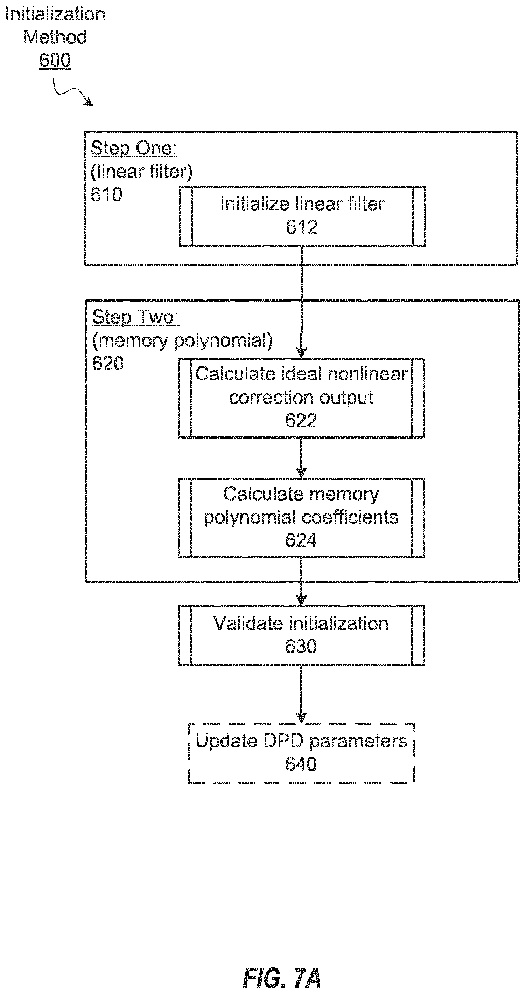

Referring now to FIG. 7A, the initialization method 600 is illustrated as a flow diagram. The initialization method 600 initializes the memory polynomial DPD architecture 350 in FIG. 3B. Additionally or alternatively, the initialization method 600 may also be used to initialize the memoryless DPD architecture 350' in FIG. 6. FIG. 7A shows a flow diagram of a two-step initialization method 600. This two-step method overcomes various challenges, including, e.g., that: (1) the coefficients are not linear-in-parameter; (2) the ideal nonlinear correction output is not known; and (3) the coefficients need to be effective across a wide bandwidth and for many different types of signals including multicarrier signals.

Regarding the first challenge overcome by method 600 (i.e., the coefficients are not linear-in-parameter), the output of the above-discussed DPD architecture 350 depends nonlinearly on the coefficients of the DPD architecture 350, and, therefore, the DPD architecture 350 is not linear in the parameters. Consequently, the least squares (LS) algorithm cannot be used to calculate the coefficients of the DPD architecture 350. However, by splitting the initialization method 600 into two steps, the respective steps separately become linear-in-parameter. As discussed in more detail below, the two-step method 600 overcomes the fact that, as a whole, the DPD architecture is not linear-in-parameter. This is achieved by using step one 610 to determine the coefficients of the linear filter 355. Then, once the linear filter coefficients are known, the problem reduces to solving for the memory polynomial 365 to invert a system of linear distortion #1 and nonlinear distortion without the linear distortion #2, which is linear-in-parameters. Thus, the second step 620, which determines the coefficients of the memory polynomial, may be performed using a least squares (LS) algorithm, as opposed to a more complicated algorithm as would be required if a single step method were used instead of the two-step method discussed herein.

Regarding the second challenge overcome by method 600, calculating DPD coefficients in step two 620 is straightforward once the ideal nonlinear correction output is known, but the ideal nonlinear correction output is not known. Accordingly, before the DPD coefficients are calculated in process 624, the ideal nonlinear correction outputs are determined in process 622. Determining the ideal nonlinear correction output is achieved using an iterative IMD cancelation method, as discussed in more detail below. This method has been shown to be robust, and works for a variety of different signal types, frequencies, and bandwidths.

Regarding the third challenge overcome by method 600, once the DPD architecture 350 has been initialized using the initialization method 600, the DPD architecture 350 is preferably effective for many different signal types over a wide bandwidth. Other methods of initializing are not robust because in other methods the DPD coefficients are typically initialized or adapted for a specific signal. To overcome the limitations of these other initialization methods, in certain non-limiting examples, the methods herein use a set of multi-tone sounding waveforms, which are described in more detail below, to more fully characterize the HPA 130, such that the DPD architecture 350 is effectively initialized for different signal types, frequencies, and bandwidths.

In step one 610 of method 600, the coefficients for the linear filter 355 are found using a sounding method, which is described in more detail below. Once the linear filter 355 is known, the system becomes linear-in-parameters, making the memory polynomial coefficients easier to find in step two 620.

In step two 620 of method 600, the memory polynomial coefficients are found. As discussed above, one challenge with DPD initialization is that the ideal nonlinear correction output is not known. To overcome this problem, an IMD cancelation technique is used to determine the ideal nonlinear correction output. Then based on the determined ideal nonlinear correction output, the memory polynomial coefficients can easily be calculated using the least squares algorithm because the system is linear-in-parameter due to the prior determination of the linear filter 355.

In process 630 of method 600, the DPD architecture 350 is validated. Validation of the initialized DPD architecture 350 includes setting the parameters/coefficients of the linear filter 355 and the memory polynomial 365 to the values determined during step one 610 and step two 620. In certain implementations, the DPD architecture 350 is then validated by applying various test waveforms to the DPD architecture 350 and confirming that the output signal from the HPA agrees with the applied test waveforms that were input to the DPD architecture 350.

Optionally, in step 640 method 600, the parameters/coefficients to the DPD architecture 350 may be updated periodically or continuously during real time operation using either an indirect or direct learning method.

Returning to step one 610 of method 600, the coefficients for the linear filter 355 are found using a sounding method based on multi-tone signals. As discussed in M. Weiss, C. Evans and D. Rees, "Identification of nonlinear cascade systems using paired multisine signals," IEEE Trans. Instrum. Meas., vol. 47, pp. 332-336, Feb. 1998 (hereinafter "Weiss"), which is incorporated herein by reference, the linear subsystems of a nonlinear cascade model may be identified by measuring the Volterra kernel of the system using various multi-sine test signals, and thereby generating a system of equations for the linear filter coefficients based on a number of common frequency combinations (e.g., ω₁+ω₂, ω₁-ω₂, 2ω₁, 2ω₂, etc.) resulting from a second-order nonlinearity. The method described herein adapts these insights to determine the coefficients of the linear filter 355 based on odd-order frequency components generated by multi-tone signals interacting via a third-order nonlinearity (or another odd-order nonlinearity).

As discussed above, the third-order nonlinearity (and other odd-order nonlinearities) are important in communications and other applications because the odd-order nonlinearity may produce in-band signals, whereas the even-order frequency components are more likely to be out of band. In step one 610, the linear filter coefficients are determined by inputting multi-tone signals into the HPA 130, and then measuring the levels of the third-order frequency components in the output from the HPA 130 (e.g., the levels of the third-order intermodulation distortion (IMD3)). Using the measured IMD3 levels, a system of linear equations is compiled and then solved to find linear distortion #2 as a function of frequency. The linear filter 355 is the inverse of the linear distortion #2. For example, the inverse of the model the linear distortion #2 may be calculated in the frequency domain, and the result converted to the time domain (e.g., using an inverse fast Fourier transform (IFFT)) to generate the coefficients/taps of the linear filter 355.

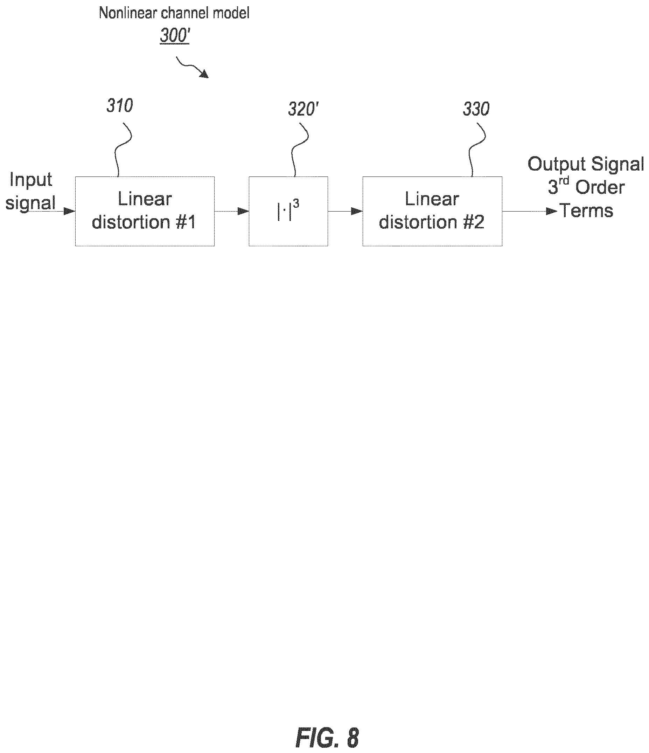

For the input to the HPA130, the multi-tone input signal includes two sinusoidal signals, which respectively are given by: ${V}_{1} cos \left({ω}_{1}t+{ϕ}_{1}\right) ,$ and ${V}_{2} cos \left({ω}_{2}t+{ϕ}_{2}\right) ,$ wherein *V*₁ and *V*₂ are the amplitudes of the two sinusoids (and in some examples are assumed to be equal), and *ω*₁ and *ω*₂ (*ω*₁ < *ω*₂) are their frequencies, and, without loss of generality, their respective phases *ϕ*₁, and *ϕ*₂ are assumed to be zero. As discussed with reference to in FIG. 3A, an HPA 130 together with the upstream and downstream electrical components may be represented as a nonlinear channel model 300 having three cascaded blocks: block 310 representing linear distortion #1; block 320 representing the nonlinear distortion (with memory in certain examples and without memory in other examples); and block 330 representing linear distortion #2. When the input to the three-block model 300 is a multi-tone signal, i.e., *V*₁ cos(*ω*₁*t*) + *V*₂ cos(*ω*₂*t*), the output will have various nonlinear frequency components. Singling out just the third-order components, the three-block model 300 may be simplified and reduced to the modified three-block model 300' shown in FIG. 8 in which the second block 320' only generates third order terms.

Given the simplified model in FIG. 8, the approach discussed in Weiss can be modified in several ways (e.g., using third-order terms, as opposed to second-order terms) to identify and invert the linear response for the modified three-block model 300' using multi-tone signals. Like the second-order system in Weiss, the modified three-block model 300' is a Wiener-Hammerstein system (linear→ nonlinear →linear). The initialization process 612 in step one 610, uses the third-order nonlinear terms (e.g., the IMD3s).

The linear filter initialization process 612 assumes that the contributions to the third-order intermodulation distortion (IMD3) frequency component that arise from higher-order nonlinearities are negligible relative to the third-order contribution. To ensure this assumption is satisfied, the output backoff (OBO) can be increased to reduce the relative strength of these higher-order contributions to the IMD3s. During process 612, the OBO is set high enough so that this assumption is valid. The linear filter initialization process 612 has the advantage of being linear-in-parameter, which contrasts with other methods that attempt to identify simultaneously the coefficients of the nonlinear and linear blocks 310, 320, and 330. Consequently, the linear filter initialization process 612 can be solved using a least squares (LS) method. Further, the linear filter initialization process 612 uses multi-tone signals, which converts the problem of identifying and inverting the linear distortion #2 to the frequency domain. Additionally, the problem of identifying and inverting the linear distortion #2 is separated into two separate LS problems: one LS problem for the phase and another LS problem amplitude. Although, process 612 can identify both the linear distortion #1 and the linear distortion #2, here the focus is on linear distortion #2 because, as shown in FIG. 5, linear distortion #2 is related to linear filter 355 (i.e., linear filter 355 corrects for the linear distortion #2). The significance of correcting the linear distortion #2 is that so doing makes step two 620 linear-in-parameter, as discussed in more detail below.

The linear filter initialization process 612 inputs the multi-tone signals and measures the resultant third-order intermodulation distortion (IMD3) output from the nonlinear channel 300. In certain implementations, the multi-tone signals are generated according to the multi-tone sounding method described below. The measured IMD3 signals include a lower third-order intermodulation distortion (IMDL3), which is at frequency 2*ω*₁ - *ω*₂, and higher third-order intermodulation distortion (IMDH3), which is at frequency 2*ω*₂ - *ω*₁. The lower third-order intermodulation distortion (IMDL3) is given by ${a}_{2}^{\left(2{ω}_{2}-{ω}_{1}\right)} {\left({a}_{1}^{\left({ω}_{1}\right)} {V}_{1}\right)}^{2} {a}_{1}^{\left({ω}_{2}\right)} {V}_{2} cos \left(\left(2{ω}_{1}-{ω}_{2}\right)t+2{ϕ}_{1}^{\left({ω}_{1}\right)}-{ϕ}_{1}^{\left({ω}_{2}\right)}+{ϕ}_{2}^{\left(2{ω}_{2}-{ω}_{1}\right)}\right) \times {C}_{NL} ,$ wherein *C_{NL}* is the contribution due to the nonlinear distortion block 320. The symbol ${a}_{i}^{\left({ω}_{j}\right)}$ represents an amplitude change, the subscript *i* indicates the amplitude change is due to linear distortion # *i* and the superscript (*ωⱼ*) indicates the angular frequency corresponding to the amplitude change. The symbol ${ϕ}_{i}^{\left({ω}_{j}\right)}$ represents a phase change, wherein the subscript *i* indicates the phase change is due to linear distortion # *i*, and the superscript (*ωⱼ*) indicates the angular frequency corresponding to the phase change. The higher third-order intermodulation distortion (IMDH3) is given by ${a}_{2}^{\left(2{ω}_{1}-{ω}_{2}\right)} {a}_{1}^{\left({ω}_{1}\right)} {V}_{1} {\left({a}_{1}^{\left({ω}_{2}\right)}{V}_{2}\right)}^{2} cos \left(\left(2{ω}_{2}-{ω}_{1}\right)t+2{ϕ}_{1}^{\left({ω}_{2}\right)}-{ϕ}_{1}^{\left({ω}_{1}\right)}+{ϕ}_{2}^{\left(2{ω}_{1}-{ω}_{2}\right)}\right) \times {C}_{NL} .$

For each of the above frequency component, separate phase and amplitude equations can be written. Taking the logarithm of the above equations for the IMDL3 and IMDH3 separates the phase equations from the amplitude equations. Additionally, the resultant equations become linear in the respective parameters. That is, the equations can be written as a set of linear equations (e.g., a matrix), such that the coefficients can be solved for using matrix algebra.

For example, the phase equations for the IMDL3 and IMDH3 frequency components are respectively ${ϕ}_{L} \left[{ω}_{1}, {ω}_{2}\right] = 2 {ϕ}_{1}^{\left({ω}_{1}\right)} - {ϕ}_{1}^{\left({ω}_{2}\right)} + {ϕ}_{2}^{\left(2{ω}_{2}-{ω}_{1}\right)} ,$ and ${ϕ}_{H} \left[{ω}_{1}, {ω}_{2}\right] = 2 {ϕ}_{1}^{\left({ω}_{2}\right)} - {ϕ}_{1}^{\left({ω}_{1}\right)} + {ϕ}_{2}^{\left(2{ω}_{1}-{ω}_{2}\right)} ,$ wherein *ϕ_{H}*[*ω*₁, *ω*₂] and *ϕ_{L}* [*ω*₁, *ω*₂] are respectively the measured phases of the IMD3H and IMD3L. The phase equations are converted to matrix form and the matrix equations for all the multi-tone signals in the set are stacked to setup a matrix equation that can be solved (e.g., by using a least-squares (LS) algorithm) to obtain estimates for the respective phases. By carefully choosing the pairs of frequencies for the multi-tone signals, the phase matrix equation can be ensured to not be underdetermined.

The equations for the amplitude in dB of IMD3L and IMD3H are: ${A}_{L} \left[{ω}_{1}, {ω}_{2}\right] = ln \left|{a}_{2}^{\left(2{ω}_{2}-{ω}_{1}\right)}\right| + 2 ln \left|{a}_{1}^{\left({ω}_{1}\right)}\right| + ln \left|{a}_{1}^{\left({ω}_{2}\right)}\right| + {c}_{L} ,$ and ${A}_{H} \left[{ω}_{1}, {ω}_{2}\right] = ln \left|{a}_{2}^{\left({ω}_{1}-{ω}_{2}\right)}\right| + ln \left|{a}_{1}^{\left({ω}_{1}\right)}\right| + 2 ln \left|{a}_{1}^{\left({ω}_{2}\right)}\right| + {c}_{H} ,$ wherein *A_{L}*[*ω*₁*,ω₂*]*=*ln|*IMDL*3/*C_{NL}*| and *A_{H}*[*ω*₁*,ω₂*]*=*ln|*IMDH*3/*C_{NL}*| are derived from the measured amplitudes of the IMD3H and IMD3L, the operation ln|·|is the logarithm function, and *c_{L}* = 2ln|*V*₁| + ln|*V*₂| and *c_{H}* = ln|*V*₁| + 2ln|*V*₂| *V*₂ represent known constants derived from the amplitudes of the input sinusoids. These amplitude equations are converted to matrix form and the matrix equations for all the multi-tone signals in the set are stacked to setup a matrix equation that can be solved (e.g., by using an LS algorithm) to obtain estimates for the respective amplitudes. By carefully choosing the pairs of frequencies for the multi-tone signals, the amplitude matrix equation can be ensured to not be underdetermined. For example, the sounding method described below can be used to determine the multi-tone signals.

For the linear distortion #2, solving the matrix equations provides the amplitudes ${a}_{2}^{\left({ω}_{j}\right)}$ and phase ${ϕ}_{2}^{\left({ω}_{j}\right)}$ distortions at a series of discrete frequencies *ωⱼ*. For frequencies other than these discrete frequencies *ωⱼ,* the linear distortion #2 amplitudes and phases may be obtained by interpolated or extrapolated (e.g., linear interpolation, quadratic interpolation, cubic interpolation, spline-based interpolation, etc.). In certain examples, the inverse of the linear distortion #2 may be calculated in the frequency domain, and then the inverse of the linear distortion #2 may be converted to a time-domain linear filter 355, such as a finite impulse response (FIR) filter. This conversion may be performed by taking a fast Fourier transform (FFT) or discrete-time Fourier transform (DFT) of the frequency-domain inverse of the linear distortion #2. The linear filter 355 is used to correct/reduce the linear distortion #2.

In certain examples, the step of determining the phase distortions ${ϕ}_{2}^{\left({ω}_{j}\right)}$ and ${ϕ}_{1}^{\left({ω}_{j}\right)}$ may include unwrapping the phasing using a two-dimensional phase unwrapping algorithm. For example, the two-dimensional phase unwrapping algorithm may be applied before setting up the LS matrixes applying.

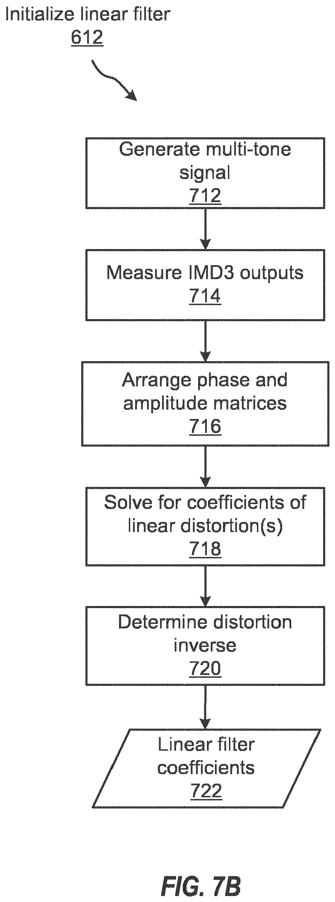

FIG. 7B shows a flow diagram of process 612 to initialize the linear filter 355. In step 712, the multi-tone signal is generated. The initialization process can be performed using multiple multi-tone signals. In step 714, the levels of the IMD3 signal are measured at the output of the nonlinear channel 300. In step 716, the linear equations for the levels of the IMD3 signal are converted to matrix equations. In step 718, the matrix equations are solved to determine the amplitude and phase values of the linear distortion #2 as a function of frequency. In step 720, the inverse of the linear distortions #2 are determined for the time domain, resulting in the coefficient values or taps 722 for the linear filter 355.

Now the multi-tone sounding method is described. The HPA 130 may be sounded using a set of multi-tone signals. For example, the frequencies of the set of multi-tone signals may be selected similar to a frequency selection method described in G. Vandersteen and J. Schoukens, "Measurement and identification of nonlinear systems consisting of linear dynamic blocks and one static nonlinearity," IEEE Transactions on Automatic Control , 44, pp. 1266-1271 (1999) and in M. Schoukens and K. Tiels, "Identification of block-oriented nonlinear systems starting from linear approximations: A survey," Automatica, 85, pp. 272-292 (2017), both of which are incorporated herein by reference in their entirety. For example, a set of multi-tone excitations may be selected to include all multi-tone excitations that are harmonically related at frequencies kω₀ for k = 1... 31, wherein ω₀ is a predefined frequency (e.g., ω₀ = 2π 625 kHz). The two spectral components may have predefined amplitudes (e.g., the same amplitude), and may have a uniformly distributed phase relationship in the range [0, 2π].

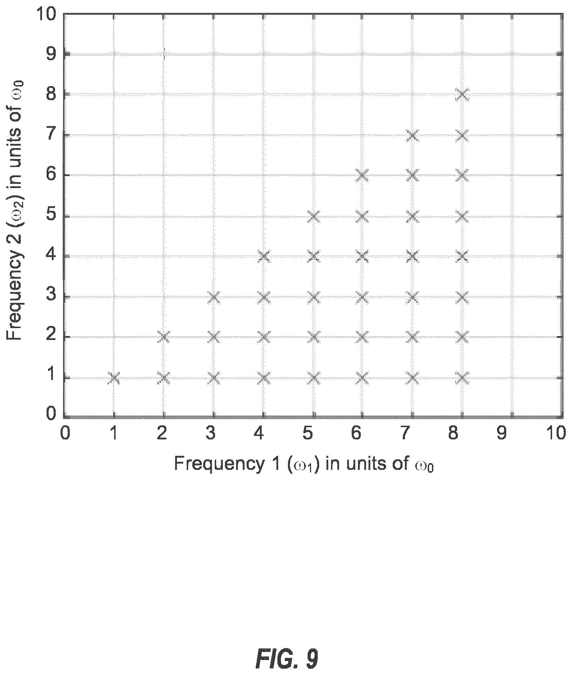

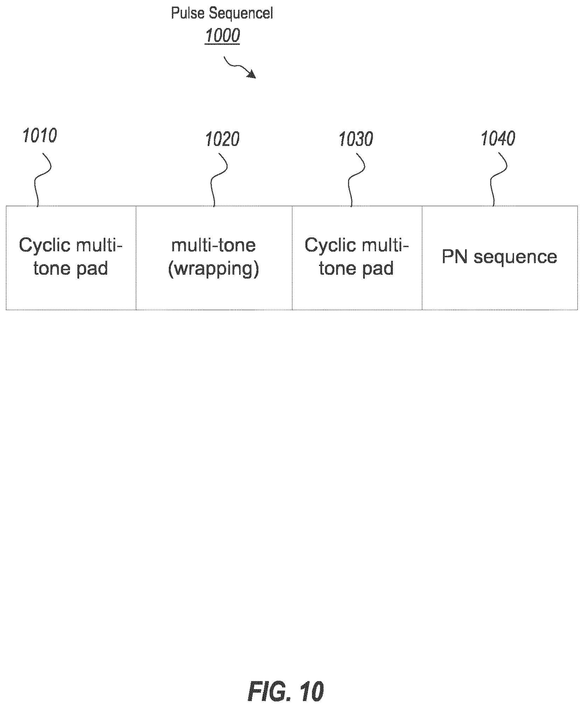

FIG. 9 shows a diagram demonstrating a set of multi-tone signals. In this plot, each 'x' represents a multi-tone signal and the horizontal and vertical axes are respectively the frequencies of each multi-tone signal. In this example, the multi-tone signals span a range of [ω₀,8ω₀]. In testing, each pair of multi-tone signals is used as input to the HPA, generating the IMD3 outputs that are used in step one 610. In certain examples, a synchronization (sync) signal is used to align the phase among the various signals, as discussed in more detail below with reference to FIG. 10. Experiments performed to generate DPD coefficients calculated using the set of multi-tone signals set shown in FIG. 9 demonstrate good DPD performance for a wide range of different signal types over a wide frequency band.

The phases of the multi-tone signal components after nonlinear distortion (i.e., ω₁, ω₂, IMD3H, IMD3L, etc.) are used for calculating the DPD coefficients. These phases can be measured and synchronized relative to a common reference for all multi-tone signals in the set. In some examples, to measure these phases all multi-tone signals in the set are synchronized to a common reference. Measurement and synchronization is accomplished in certain examples by embedding a pseudorandom noise (PN) sequence 1040 in the multi-tone signals, and the receive signals are time aligned using the PN sequence 1040. In certain examples, the pulse sequence 1000 shown in FIG. 10 is used to synchronize the signals. The PN sequence 1040 of the pulse sequence 1000 may be identical for all multi-tone signals in signal set. Additionally, using a fast Fourier transform (FFT), a multi-tone signal that exactly wraps (the beginning and end of the of the signal are phase continuous) may be used so the signal components amplitude and phase can be measured using an FFT, according to a non-limiting example. Cyclic multi-tone pads 1010 and 1030 are respectively added before and after the wrapping multi-tone signal 1020 to mitigate transients from the PN sequence.

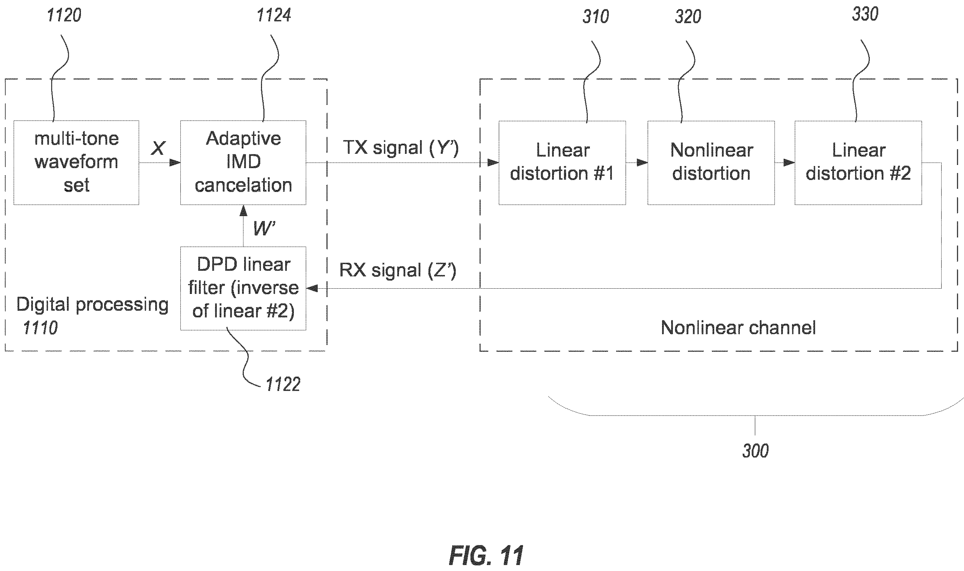

FIG. 11 shows a block diagram that illustrates an implementation of process 622 for calculating the ideal nonlinear correction output, which will later be used in process 624 to calculate the coefficients of the memory polynomial 365. In block 1120, a multi-tone waveform from the set of multi-tone waveforms is generated and output to an adaptive IMD cancelation block 1124. The adaptive IMD cancelation 1124 (and the process 622) is performed in the digital domain using various digital processing circuitry 1110, such as in an application specific integrated circuit (ASIC), a special purpose digital signal processor (DSP), a graphics processing unit (GPU), or a central processing unit (CPU). In certain examples, the digital domain output from the adaptive IMD cancelation 1122 is converted from a digital signal to analog signal using a digital to analog converter (DAC) circuit, and then the output is mixed with an intermediate frequency signal to convert the analog signal from baseband signal to a carrier wave signal, e.g., a radio frequency (RF) signal, a megahertz (MHz) signal, a gigahertz (GHz) signal, a microwave signal, a millimeter wave signal, etc. The carrier wave signal is the transmitted (TX) signal that passes through the HPA and other electrical components in the transmit path (e.g., the nonlinear channel 300).

As discussed above, step one 610 determines the inverse of linear distortion #2, and the linear distortion #2 is represented by block 330 of the three-block nonlinear channel model 300. In the DPD linear filtering 1122, this inverse of the linear distortion #2 is applied to the output from the nonlinear channel 300 (e.g., the HPA and accompanying circuitry). Having canceled out the linear distortion #2, the adaptive IMD cancelation block in process 624 cancels the linear distortion 310 and the nonlinear distortion 320. An iterative process is used to update the IMD cancelation block 1124 to cancel the IMD for a wide range of signal types, frequencies, and bandwidths. In many cases linear distortion #2 is negligible and can be ignored. In this case step one (610) can be skipped. In this situation the first linear filter (355) and 1122 can be eliminated.

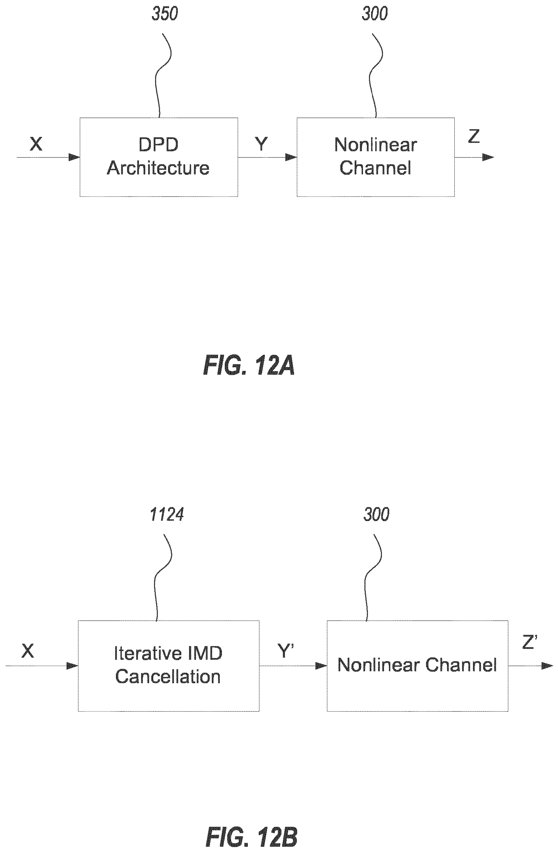

FIGs. 12A and 12B illustrate additional details about process 622 for calculating the ideal nonlinear correction output. The nonlinear channel can be represented as various functions *L*₁(*x*)*, NL*(*x*), and *L*₂(*x*) corresponding to the respective distortions. Accordingly, the nonlinear channel 300 may be represented as the function *y = L*₂ (*NL*(*L*₁(*x*)))*.* As discussed above, block 1122 functions to approximately invert the linear distortion #2 (i.e., *L*₂(*x*)) represented by block 330. Accordingly, block 1122 may be represented as the function *L̃*₂ ⁻¹(*x*), wherein the tilde represents that *L̃*₂⁻¹(*x*) approximates the exact inverse *L*₂⁻¹(*x*)*.* Similarly, IMD cancelation block 1124 functions to approximately invert the combination of linear distortion #1 (represented by block 310) together with the nonlinear distortion (represented by block 320). IMD cancelation block 1124 may be represented as the function ${{LNL}^{˜}}^{- 1} \left(x\right)$, which approximately inverts the function *NL*(*L*₁(*x*)). For example, ${x}^{˜} = {{LNL}^{˜}}^{- 1} \left(NL\left({L}_{1}\left(x\right)\right)\right)$ and *x̃* is an amplified approximation of the input value *x* (e.g., *x̃* ≈ *gx,* wherein *g* is the gain of the HPA).

FIG. 12A illustrates an example of how the DPD system is used. And FIG. 12B illustrates an example of how the iterative IMD cancellation is performed. In FIG. 12A, the DPD architecture 350 receives the input *X* and outputs *Y,* i.e., $Y = {{LNL}^{˜}}^{- 1} \left({{{L}^{˜}}_{2}}^{- 1}\left(X\right)\right)$. Then the nonlinear channel 300 receives the input *Y* and outputs *Z*, i.e., *Z = L*₂ (*NL*(*L*₁(*Y*))). When the DPD architecture 350 is a good approximation of an inverse of the nonlinear channel 300, the output *Z* is a good approximation of the input *X*, which has been amplified by the gain *g* (e.g., *Z* ≈ *gX*). Ideally, the DPD architecture 350 will perfectly invert the nonlinear channel so that *Z* = *gX*.

Referring now to FIG. 12B, one way of calculating the memory polynomial coefficients is to first determine the output $Y ′ = {{LNL}^{˜}}^{- 1} \left(X\right)$ that perfectly inverts the combination of the nonlinear distortion and the linear distortion #1, i.e., *NL*(*L*₁(*Y*)). Once the input *X* and output *Y'* are known, then these known values are used in process 624 to determine the memory polynomial coefficients (e.g., the memory polynomial performs the function ${{LNL}^{˜}}^{- 1}$). Before process 624, an iterative IMD cancellation method is used in process 622 to determine the ideal nonlinear correction output. The IMD cancellation is used to find the ideal DPD output *Y'*.

In FIG. 12B, the iterative IMD cancelation block 1124 receives the input *X* and outputs *Y',* which is an estimate of the ideal nonlinear correction output, i.e., $Y ′ = {{LNL}^{˜}}^{- 1} \left(X\right)$. Then the nonlinear channel 300 receives the input *Y'* and generates the output *Z'*, i.e., *Z' = L*₂ (*NL*(*L*₁(*Y'*))). Because this process does not include the inverse to linear distortion #2 (i.e., *L̃₂*⁻¹(*x*)), the output *Z'* approximates the input X with the linear distortion #2, i.e., *Z'* ≈ *L*₂ (*NL*(*L*₁(*Y*))) *= L*₂(*X*). Accordingly, in FIG. 11 the RX signal first passes through the DPD linear filter block 1122 before being used by the adaptive IMD cancellation block 1124. That is, the RX signal in FIG. 11 (i.e., *Z'*) is received by the DPD linear filter block 1122, which was derived previously in step one 610, to generate an output *W' = L̃*₂ ⁻¹(*Z'*). An iterative process, such as a multidimensional search, is performed to determine the ideal nonlinear correction output that minimizes IMD terms in the signal *W'*.

FIG. 11 illustrates a non-limiting example of the process 622 for calculating the ideal nonlinear correction output. In this process, a known multi-tone signal passes through and is modified by digital processing circuitry that performs an adaptive IMD cancelation process to generate a transmit (TX) signal. The TX signal is then transmitted through the nonlinear channel 300, which is modeled as linear distortion #1 block 310, nonlinear distortion block 320, and linear distortion #2 block 330. Then the output of the channel (e.g., the RX signal) is measured, after which the linear distortion #2 is canceled/mitigated using digital processing circuitry 1112, which performs the DPD linear filter processing that is the inverse of the linear distortion #2. The DPD linear filter performed by the digital processing circuitry 1112 is essentially (if not exactly) the same as the first linear filter 355, which performs the processing that is the inverse of the linear distortion #2 previously obtained in step one 610. The resultant signal *W'* from the DPD linear filter 1122 is then captured, and the IMD levels are derived from the captured signal *W'*. Next, the estimate of the ideal nonlinear correction output *Y'* is updated to reduce the IMD levels. Essentially, process 622 performs an iterative process of searching for the ideal nonlinear correction output *Y'* that cancels the IMD components in *W'*. Thus, process 622 is a learning process to generate anti-IMD signals that cancel the IMD signals in the nonlinear channel.

Process 622 may be an iterative process and continues until the IMD levels (or error signal derived from the IMD levels) is minimized. For example, in certain examples a set of stopping criteria are set for process 622. These stopping criteria can include a predefined IMD threshold (or error signal threshold). If the measured IMD levels fall below the predetermined threshold for a given number of iterations, then process 622 is complete and method 600 continues to process 624. These stopping criteria can also include a stopping criterion based on a maximum number of iterations. For example, if the maximum number of iterations is exceeded, then process 622 is complete and method 600 continues to process 624. These stopping criteria can include additional criteria.

Any one or more of various adaption methods may be used to perform the iterative IMD cancelation in process 622. For example, in certain examples, the adaption method can be a convex optimization method (e.g., a gradient descent method, Lagrange multiplier method, a LS method, etc.), a genetic algorithm, a simulated annealing method, a brute force method, or some other optimization method. Alternatively or additionally, a brute force method may be used to perform the iterative IMD cancelation in process 622. Further, a first search method (e.g., a fast-converging search method) may be used initially, and then a second search method (e.g., a high-precision search method) may be used in the end to find the ideal nonlinear correction output that will be passed on to process 624.

For the optimization adaption, the error signal to be minimized may include a combination (e.g., a weighted sum) of several IMD components. For example, the error signal may be a weighted sum of the levels of the measured IMD components of the captured signal *W'*. The quantity of IMD components used in the error signal may be maintained at a manageable number of IMD components because multi-tone signals are used, as opposed to signals having more frequencies resulting in more combinations of frequencies (i.e., more IMD components). The list below gives a few notes about the IMD cancelation algorithm:

As discussed above, process 622 may be viewed as creating anti-IMDs that cancel the IMDs generated in the nonlinear channel 300. Further, process 622 functions to equalize the fundamental frequencies ω₁ and ω₂ such that the fundamental frequencies have a desired amplitude and no phase shift (or at least a uniform/consistent phase shift) at the output of the nonlinear channel 300.

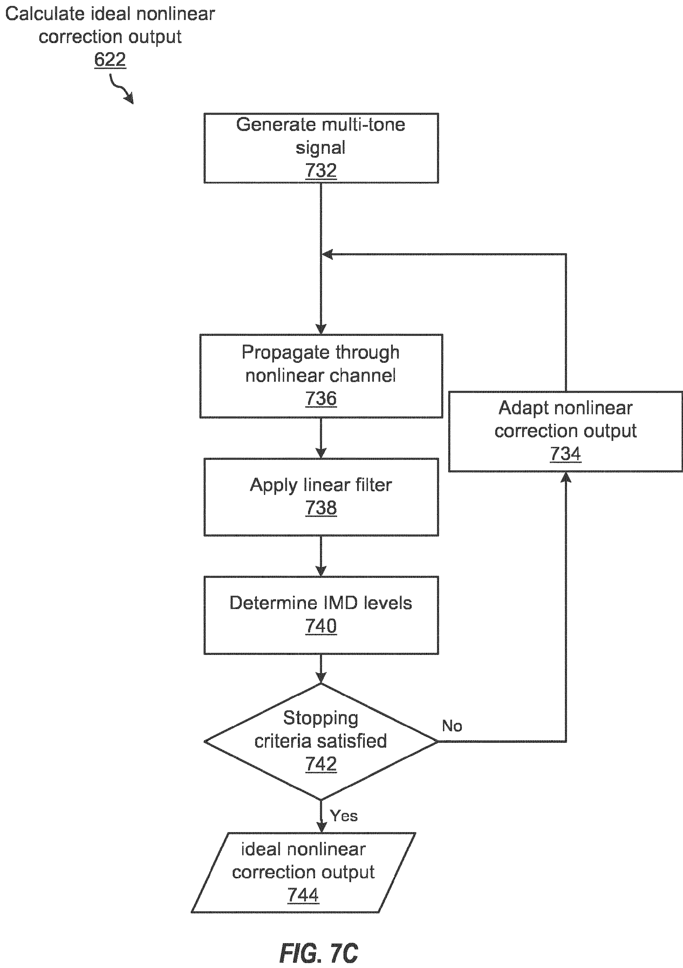

FIG. 7C shows a flow diagram of process 622 to calculate ideal nonlinear correction output. In step 732, the multi-tone signals *X* are generated and are input to adaptive IMD cancelation block 1124. Given the multi-tone signals *X* and in the feedback *W'* from the DPD linear filter block 1122, in step 736, the adaptive IMD cancelation block 1124 predicts/guesses a signal *Y'* for the ideal nonlinear correction output, which is output from the IMD cancelation block 1124. In step 736, the output *Y'* from the adaptive IMD cancelation block 1124 propagates through the nonlinear channel 300, generating thereby the signal *Z'*. In step 738, the DPD linear filter block 1122 applies the linear filter 355 to the signal *Z'*, generating thereby the signal *W'* . In step 740, the. In step 742, the IMD cancelation block 1124 determines IMD levels or determines an error signal based on the IMD levels. In step 744, the determined IMD levels or error signal based on the IMD levels are compared to stopping criteria. When the stopping criteria are not satisfied, the process 622 continues at step 734 by guessing a new signal *Y'* for the ideal nonlinear correction output. When the stopping criteria are satisfied, the process 622 stops and outputs the signal *Y'* for the ideal nonlinear correction output.

Referring now to process 624, the memory polynomial initialization is linear-in-parameters (e.g., the equations are linear with respect to the memory polynomial coefficients that are being estimated) because the DPD linear filter 1122 has been corrected for the linear distortion #2. Consequently, in process 624, the memory polynomial coefficients can be calculated using an LS algorithm where the ideal multi-tone signal *X* is the input and the IMD cancelation algorithm output *Y'* is the ideal nonlinear correction output that was determined in process 622. The memory polynomial coefficients are then estimated based on the input *X* and outputs *Y'*. In certain nonlimiting examples, the memory polynomial coefficients are the weighting coefficients in FIG. 4 for the first-order term (i.e., w₁₀, w₁₁, w₁₂), third-order term (i.e., w₃₀, w₃₁, w₃₂), and fifth-order term (i.e., w₅₀, w₅₁, w₅₂). In process 624, the memory polynomial coefficients are determined such that they generate the output Y' in response to the input X. In FIG. 4, the input to the memory polynomial 365 is illustrated as *"x''* and the output is illustrated as "*z*".

It is understood that the disclosed method may be used with different architectures used for the memory polynomial 365, and that different architectures may have different numbers of order terms and different numbers of weighting coefficients. It is understood that the disclosed method may find/calculate the memory polynomial coefficients using other methods than the LS method discussed above. Note that in some examples, a different DPD algorithm may be used, such as a generalized memory polynomial.

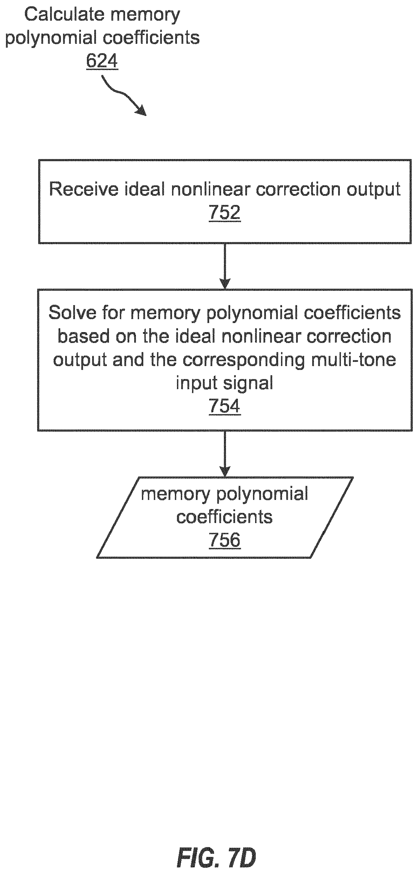

FIG. 7D shows a flow diagram of process 624 to calculate the coefficients of the memory polynomial. In step 752, the signal *Y'* representing the ideal nonlinear correction output is received from process 622. In step 754, the memory polynomial coefficients are solved for based on the ideal nonlinear correction output *Y'* and the corresponding multi-tone input signal *X*, resulting in the coefficients 756 of the memory polynomial 365.

To validate the DPD architecture 350, the accuracy of this initialized DPD architecture 350 may be quantified by applying input X to the DPD architecture 350 and confirming that the expected output is generated from the DPD architecture 350. Additionally or alternatively, the DPD architecture 350 may be validated by applying input *X* to a combination of the DPD architecture 350 and the nonlinear channel 300, and then confirming that the expected output is generated. The respective parts/blocks of the DPD architecture 350 may be validated separately. For example, the memory polynomial 365 may be validated by applying input *X* to the memory polynomial 365 and confirming that the expected output *Y'* is generated by the memory polynomial 365. The validation process 630 may also be performed using signals multi-tone that are different from the two tone signal set used to perform the two-step initialization. These signals would be representative of operational signals used in the systems. The DPD performance would be quantified by applying input a representative input signals to the DPD architecture 350 and confirming that the expected outputs are generated from the DPD architecture 350.

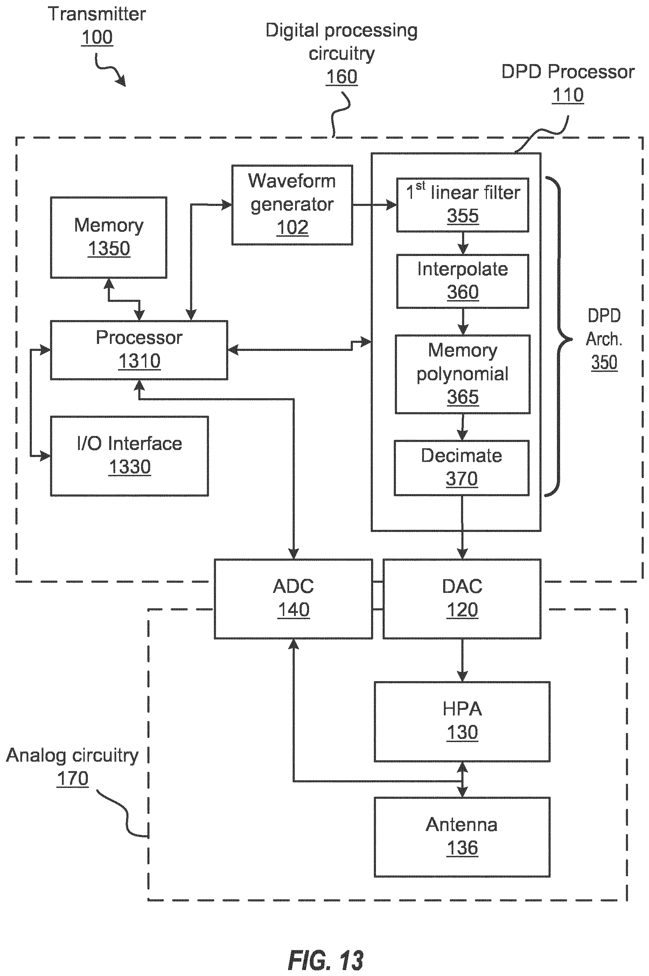

FIG. 13 illustrates a block diagram of the transmitter 100. The processor 1310 can be any programmable microcontroller, microprocessor, microcomputer or chips that can be configured by software instructions (applications) to perform a variety of functions, including functions of various examples described herein. The processor 1310 may be field programable gate array (FPGA), an application specific integrated circuit (ASIC), or other circuitry configured to perform instructions on sets of data and store results.

Software applications performing some examples described herein (e.g., method 600) can be stored in the memory 1350 before they are accessed and loaded into the processor 1310. The processor 1310 can include onboard memory and/or have access to the memory 1350 sufficient to store the software instructions. The memory 1350 can also include an operating system (OS). The memory 650 may include FLASH memory, RAM, ROM, PROM, EPROM, EEPROM, magnetic storage drive, or any type of non-transitory computer readable medium.

Additionally, the memory 1350 can be a volatile or nonvolatile memory, such as flash memory, or a mixture of both. For the purposes of this description, a general reference to memory refers to all memory accessible by the processor 1310, including memory 1350, removable memory plugged into the transmitter 100, and memory within the processor 1310 itself, including a secure memory.

The transmitter 100 can also include an input/output (I/O) interface 1330 to receive and transmit signal to peripheral devices and sensors, or to communicate with an external controller. For example, the I/O interface 1330 may include a high-speed parallel interface. Additionally or alternatively, the I/O interface 1330 may include a serial interface. The I/O interface 1330 may include an I/O bus and a physical port, such as a universal serial bus (USB) port, or small computer system interface (SCSI) port, or other physical digital communicans port.

As discussed in reference to FIG. 1, the transmitter 100 includes, within the digital processing circuitry 160, a waveform generator 102 that transmits a digital waveform to the DPD processor 110. Both the waveform generator 102 and the DPD processor 110 can be controlled by the processor 1310. For example, the processor 1310 can control the waveform generator 102 to generate the various multi-tone signals used in the two-step initialization method 600, and the processor 1310 can control the DPD processor 110 to set the values of the linear filter 355 and the coefficients of the memory polynomial 365. In FIG. 13, the DPD processor 110 is illustrated as having the DPD architecture 350, but other configurations for the DPD processor 110 are contemplated, including, e.g., the modified DPD architecture 350'.

The signal converted to an analog signal by a digital-to-analog converter (DAC) 120. The resultant analog signal is then amplified by the HPA 130, after which a portion of the output from the HPA 130 is converted back to digital via an analog-to-digital converter (ADC) 140. The resultant digital signal is fed to processor 1310 that performs a DPD coefficient initialization method 600 to initialize the coefficients used in DPD processor 110. The DPD processor 110 compensates for nonlinear and linear distortion resulting from the HPA 130 and other circuitry in the transmission path to the antenna 136.

## Claims

1. A method (600) of digital predistortion initialization, the method comprising:
receiving an original propagated electrical signal resulting from an original multi-tone electrical signal input into a nonlinear channel comprising a power amplifier;
determining (610) the coefficients of a linear filter that is configured to generate a modified input electrical signal from the original multi-tone electrical signal and that pre-compensates for the nonlinear channel, such that transmitting the modified input electrical signal through the nonlinear channel results in a modified propagated electrical signal having reduced distortions relative to the nonlinear distortions in the original propagated electrical signal;
using (620) the original input multi-tone electrical signal and the modified input electrical signal to determine nonlinear filter coefficients for a nonlinear filter, that reduces nonlinear distortions in a propagated electrical signal from the nonlinear channel when the nonlinear filter is applied to the modified input electrical signal, input into the nonlinear channel, to perform predistortion prior to the transmission of the modified input electrical signal through the nonlinear channel;
wherein determining nonlinear coefficients for the nonlinear filter is based on the modified input electrical signal and the original input electrical signal having multiple simultaneous tones;
wherein coefficients of the linear filter are determined based on measuring levels of third-order frequency components in the propagated electrical signal for determining a linear distortion as a function of frequency, wherein determining the linear distortion is based on a least-squares method for a phase and a least-squares method for an amplitude; and
wherein the modified input electrical signal is determined using an iterative process that adapts the modified input electrical signal to reduce levels of intermodulation distortion in the modified propagated electrical signal.

2. The method (600) of claim 1, wherein
the nonlinear channel has a nonlinear distortion portion, followed in sequence by a second linear distortion portion, a propagated electrical signal having second linear distortions, below a predetermined threshold, due to the second linear distortion portion, after processing by the nonlinear channel.

3. The method (600) according to claim 2, wherein
the second linear distortion portion inherently results in the original propagated electrical signal having the second linear distortions below the predetermined threshold.

4. The method (600) according to claim 2, further comprising
predistorting the original propagated electrical signal into the nonlinear channel, based on the second linear distortion portion to cause the original propagated electrical signal to be a first corrected signal having the second linear distortions below the predetermined threshold.

5. The method (600) according to claim 4, further comprising:
determining coefficients for a second linear filter that performs the predistorting of the original propagated electrical signal which reduces the second linear distortions in the propagated electrical signal; and
applying the second linear filter to the modified input signal.

6. The method (600) according to claim 5, wherein
applying the second linear filter to the input signal causes coefficients of the nonlinear filter to be linear-in-parameter, and the determining coefficients of the second filter is performed by solving for the coefficients of the second filter using a least-squares method.

7. The method (600) according to claim 5, further compromising:
initializing the second linear filter by selecting as the original propagated signal, respective multi-tone signals from a set of multi-tone signals, each multi-tone signal having a respective set of frequencies from a plurality of discrete frequencies, and the plurality of discrete frequencies being selected to span a predefined frequency range,
determining amplitude linear equations based on measured intermodulation distortion components of the propagated electrical signal, when the nonlinear channel is excited by the respective multi-tone signals from the set of multi-tone signals,
determining phase linear equations based on the measured intermodulation distortion components of the propagated electrical signal, when the nonlinear channel is excited by the respective multi-tone signals from the set of multi-tone signals, and
determining the second linear filter coefficients based on the amplitude linear equations and the phase linear equations.

8. The method (600) according to claim 1, wherein
the nonlinear filter is linear-in-parameter, and determining coefficients of the nonlinear filter is performed by solving for the coefficients of the nonlinear filter using a least-squares method using the original input multi-tone electrical signal and the modified input electrical signal.

9. The method (600) according to claim 1, wherein
the nonlinear channel has a first linear distortion portion preceding the nonlinear distortion portion, and determining nonlinear filter coefficients of the nonlinear filter further comprises selecting coefficients of the nonlinear filter that reduce distortions caused by the first linear distortion portion in addition to reducing the nonlinear distortions.

10. The method (600) according to claim 5, further compromising:
initializing the second linear filter and the nonlinear filter by generating a modified input electrical signal to be a set of multi-tone electrical signals comprising a portion having a first frequency component and a second frequency component;
transmitting the modified input electrical signal through the nonlinear channel to generate the original propagated electrical signal, the original propagated electrical signal including one or more intermodulation distortion components of the first frequency component and the second frequency component that are generated by transmitting the multi-tone electrical signal through the nonlinear channel;
wherein determining coefficients for the nonlinear filter and the second linear filter is performed using a synchronization that time synchronizes the set of multi-tone electrical signals.

## Patentansprüche

1. Ein Verfahren (600) zur Initialisierung der digitalen Vorverzerrung, wobei das Verfahren umfasst:
Empfangen eines ursprünglichen, weitergeleiteten elektrischen Signals, das aus einem ursprünglichen mehrtonigen elektrischen Signal resultiert, das in einen nichtlinearen Kanal eingegeben wird, der einen Leistungsverstärker umfasst;
Bestimmen (610) der Koeffizienten eines linearen Filters, das so konfiguriert ist, dass es aus dem ursprünglichen elektrischen Mehrton-Eingangssignal ein modifiziertes elektrisches Eingangssignal erzeugt, das den nichtlinearen Kanal vorkompensiert, sodass das Senden des modifizierten elektrischen Eingangssignals durch den nichtlinearen Kanal zu einem modifizierten elektrischen Signal führt, dessen Verzerrungen im Vergleich zu den nichtlinearen Verzerrungen im ursprünglichen elektrischen Signal reduziert sind;
Verwenden (620) des ursprünglichen elektrischen Mehrton-Eingangssignals und des modifizierten elektrischen Eingangssignals zur Bestimmung nichtlinearer Filterkoeffizienten für ein nichtlineares Filter, das nichtlineare Verzerrungen in einem durch den nichtlinearen Kanal übertragenen elektrischen Signal reduziert, wenn das nichtlineare Filter auf das modifizierte elektrische Eingangssignal angewendet wird, das in den nichtlinearen Kanal eingespeist wird, um vor der Übertragung des modifizierten elektrischen Eingangssignals durch den nichtlinearen Kanal eine Vorverzerrung durchzuführen;
wobei die Bestimmung der nichtlinearen Koeffizienten für das nichtlineare Filter auf dem modifizierten elektrischen Eingangssignal und dem ursprünglichen elektrischen Eingangssignal mit mehreren gleichzeitigen Tönen basiert;
wobei die Koeffizienten des linearen Filters auf der Grundlage der Messung der Pegel von Frequenzkomponenten dritter Ordnung im weitergeleiteten elektrischen Signal bestimmt werden, um eine lineare Verzerrung als Funktion der Frequenz zu ermitteln, wobei die Bestimmung der linearen Verzerrung auf einem Verfahren der kleinsten Quadrate für die Phase und einem Verfahren der kleinsten Quadrate für die Amplitude basiert; und
wobei das modifizierte elektrische Eingangssignal unter Verwendung eines iterativen Verfahrens bestimmt wird, das das modifizierte elektrische Eingangssignal so anpasst, dass die Pegel der Intermodulationsverzerrung im modifizierten weitergeleiteten elektrischen Signal reduziert werden.

2. Das Verfahren (600) nach Anspruch 1, wobei
der nichtlineare Kanal einen nichtlinearen Verzerrungsabschnitt aufweist, auf den nacheinander ein zweiter linearer Verzerrungsabschnitt folgt, wobei ein weitergeleitetes elektrisches Signal nach der Verarbeitung durch den nichtlinearen Kanal zweite lineare Verzerrungen unterhalb eines vorbestimmten Schwellenwerts aufweist, die auf den zweiten linearen Verzerrungsabschnitt zurückzuführen sind.

3. Das Verfahren (600) nach Anspruch 2, wobei
der zweite lineare Verzerrungsabschnitt von Natur aus dazu führt, dass das ursprüngliche weitergeleitete elektrische Signal die zweiten linearen Verzerrungen unterhalb des vorgegebenen Schwellenwerts aufweist.

4. Das Verfahren (600) nach Anspruch 2, das ferner umfasst
das Vorverzerren des ursprünglichen, weitergeleiteten elektrischen Signals in den nichtlinearen Kanal auf der Grundlage des zweiten linearen Verzerrungsabschnitts, um zu bewirken, dass das ursprüngliche, weitergeleitete elektrische Signal ein erstes korrigiertes Signal ist, bei dem die zweiten linearen Verzerrungen unterhalb des vorgegebenen Schwellenwerts liegen.

5. Das Verfahren (600) nach Anspruch 4, das ferner umfasst:
Ermitteln von Koeffizienten für ein zweites lineares Filter, das die Vorverzerrung des ursprünglichen, weitergeleiteten elektrischen Signals durchführt, wodurch die zweiten linearen Verzerrungen im weitergeleiteten elektrischen Signal reduziert werden; und
Anwenden des zweiten linearen Filters auf das modifizierte Eingangssignal.

6. Das Verfahren (600) nach Anspruch 5, wobei
das Anwenden des zweiten linearen Filters auf das Eingangssignal bewirkt, dass die Koeffizienten des nichtlinearen Filters parameterlinear sind, und das Bestimmen der Koeffizienten des zweiten Filters durch Ermitteln der Koeffizienten des zweiten Filters unter Verwendung einer least-squares-Methode.

7. Das Verfahren (600) nach Anspruch 5, das ferner umfasst:
Initialisieren des zweiten linearen Filters durch Auswählen jeweiliger Mehrtonsignale aus einer Menge von Mehrtonsignalen als ursprüngliches weitergeleitetes Signal, wobei jedes Mehrtonsignal eine jeweilige Menge von Frequenzen aus einer Vielzahl diskreter Frequenzen aufweist und die Vielzahl diskreter Frequenzen so ausgewählt ist, dass sie einen vordefinierten Frequenzbereich abdeckt,
Ermitteln von linearen Amplitudengleichungen auf der Grundlage gemessener Intermodulationsverzerrungskomponenten des weitergeleiteten elektrischen Signals, wenn der nichtlineare Kanal durch die jeweiligen Mehrtonsignale aus der Menge von Mehrtonsignalen angeregt wird,
Ermitteln von linearen Phasengleichungen auf der Grundlage der gemessenen Intermodulationsverzerrungskomponenten des weitergeleiteten elektrischen Signals, wenn der nichtlineare Kanal durch die jeweiligen Mehrtonsignale aus dem Satz von Mehrtonsignalen angeregt wird, und
Bestimmen der Koeffizienten des zweiten linearen Filters auf der Grundlage der linearen Amplitudengleichungen und der linearen Phasengleichungen.

8. Das Verfahren (600) nach Anspruch 1, wobei
das nichtlineare Filter parameterlinear ist und die Bestimmung der Koeffizienten des nichtlinearen Filters durch das Lösen nach den Koeffizienten des nichtlinearen Filters unter Verwendung einer least-squares-Methode unter Verwendung des ursprünglichen elektrischen Mehrton-Eingangssignals und des modifizierten elektrischen Eingangssignals erfolgt.

9. Das Verfahren (600) nach Anspruch 1, wobei
der nichtlineare Kanal einen ersten linearen Verzerrungsabschnitt aufweist, der dem nichtlinearen Verzerrungsabschnitt vorausgeht, und das Bestimmen der Koeffizienten des nichtlinearen Filters ferner das Auswählen von Koeffizienten des nichtlinearen Filters umfasst, die zusätzlich zur Reduzierung der nichtlinearen Verzerrungen auch die durch den ersten linearen Verzerrungsabschnitt verursachten Verzerrungen reduzieren.

10. Das Verfahren (600) nach Anspruch 5, das ferner umfasst:
das Initialisieren des zweiten linearen Filters und des nichtlinearen Filters durch Erzeugen eines modifizierten elektrischen Eingangssignals, das aus einer Reihe von Mehrton-Signalen besteht, die einen Abschnitt mit einer ersten Frequenzkomponente und einer zweiten Frequenzkomponente umfassen;
Senden des modifizierten elektrischen Eingangssignals durch den nichtlinearen Kanal, um das ursprüngliche, weitergeleitete elektrische Signal zu erzeugen, wobei das ursprüngliche, weitergeleitete elektrische Signal eine oder mehrere Intermodulationsverzerrungskomponenten der ersten Frequenzkomponente und der zweiten Frequenzkomponente enthält, die durch das Senden des elektrischen Mehrton-Signals durch den nichtlinearen Kanal erzeugt werden;
wobei die Bestimmung von Koeffizienten für das nichtlineare Filter und das zweite lineare Filter unter Verwendung einer Synchronisation erfolgt, die die Gruppe von elektrischen Mehrton-Signalen zeitlich synchronisiert.

## Revendications

1. Une méthode (600) d'initialisation de la prédistorsion numérique, la méthode comprenant:
recevoir d'un signal électrique propagé d'origine résultant d'un signal électrique multitonal d'origine entré dans un canal non linéaire comprenant un amplificateur de puissance;
déterminer (610) des coefficients d'un filtre linéaire configuré pour générer, à partir du signal électrique multitonal d'origine, un signal électrique d'entrée modifié qui précompense le canal non linéaire, de telle sorte que la transmission du signal électrique d'entrée modifié à travers le canal non linéaire aboutisse à un signal électrique propagé modifié présentant des distorsions réduites par rapport aux distorsions non linéaires du signal électrique propagé d'origine;
utiliser (620) le signal électrique d'entrée multitonal d'origine et le signal électrique d'entrée modifié pour déterminer les coefficients d'un filtre non linéaire, qui réduit les distorsions non linéaires dans un signal électrique propagé provenant du canal non linéaire lorsque le filtre non linéaire est appliqué au signal électrique d'entrée modifié, entré dans le canal non linéaire, afin d'effectuer une prédistorsion avant la transmission du signal électrique d'entrée modifié à travers le canal non linéaire;
dans lequel la détermination des coefficients non linéaires pour le filtre non linéaire repose sur le signal électrique d'entrée modifié et le signal électrique d'entrée d'origine comportant plusieurs tonalités simultanées;
dans lequel les coefficients du filtre linéaire sont déterminés sur la base de la mesure des niveaux des composantes de fréquence du troisième ordre dans le signal électrique propagé afin de déterminer une distorsion linéaire en fonction de la fréquence, la détermination de la distorsion linéaire étant basée sur une méthode des moindres carrés pour la phase et une méthode des moindres carrés pour l'amplitude; et
dans lequel l' e du signal électrique d'entrée modifié est déterminée à l'aide d'un processus itératif qui adapte le signal électrique d'entrée modifié afin de réduire les niveaux de distorsion d'intermodulation dans le signal électrique propagé modifié.

2. La méthode (600) selon la revendication 1, dans laquelle
le canal non linéaire comporte une partie de distorsion non linéaire, suivie successivement d'une deuxième partie de distorsion linéaire, un signal électrique propagé présentant des deuxièmes distorsions linéaires, inférieures à un seuil prédéterminé, dues à la deuxième partie de distorsion linéaire, après traitement par le canal non linéaire.

3. La méthode (600) selon la revendication 2, dans laquelle
la deuxième partie de distorsion linéaire a pour conséquence inhérente que le signal électrique propagé d'origine présente les deuxièmes distorsions linéaires en dessous du seuil prédéterminé.

4. La méthode (600) selon la revendication 2, comprenant en outre
une prédistorsion du signal électrique propagé d'origine dans le canal non linéaire, sur la base de la deuxième partie de distorsion linéaire, afin de faire en sorte que le signal électrique propagé d'origine devienne un premier signal corrigé présentant les deuxièmes distorsions linéaires en dessous du seuil prédéterminé.

5. La méthode (600) selon la revendication 4, comprenant en outre :
déterminer de coefficients pour un deuxième filtre linéaire qui effectue la prédistorsion du signal électrique propagé d'origine, ce qui réduit les deuxièmes distorsions linéaires dans le signal électrique propagé ; et
appliquer du deuxième filtre linéaire au signal d'entrée modifié.

6. La méthode (600) selon la revendication 5, dans laquelle
appliquer du deuxième filtre linéaire au signal d'entrée rend les coefficients du filtre non linéaire linéaires en paramètres, et la détermination des coefficients du deuxième filtre est effectuée en résolvant l'équation des coefficients du deuxième filtre à l'aide d'une méthode des moindres carrés.

7. La méthode (600) selon la revendication 5, comprenant en outre:
initialiser du deuxième filtre linéaire en sélectionnant, comme signal propagé d'origine, des signaux multitons respectifs parmi un ensemble de signaux multitons, chaque signal multiton comportant un ensemble respectif de fréquences parmi une pluralité de fréquences discrètes, et la pluralité de fréquences discrètes étant sélectionnée de manière à couvrir une plage de fréquences prédéfinie,
déterminer des équations linéaires d'amplitude sur la base des composantes de distorsion d'intermodulation mesurées du signal électrique propagé, lorsque le canal non linéaire est excité par les signaux multitons respectifs issus de l'ensemble de signaux multitons,
déterminer des équations linéaires de phase sur la base des composantes de distorsion d'intermodulation mesurées du signal électrique propagé, lorsque le canal non linéaire est excité par les signaux multitons respectifs issus de l'ensemble de signaux multitons, et
déterminer les coefficients du deuxième filtre linéaire à partir des équations linéaires d'amplitude et des équations linéaires de phase.

8. La méthode (600) selon la revendication 1, dans laquelle
le filtre non linéaire est linéaire en paramètres, et la détermination des coefficients du filtre non linéaire est effectuée en résolvant les équations pour les coefficients du filtre non linéaire à l'aide d'une méthode des moindres carrés utilisant le signal électrique d'entrée multitonal d'origine et le signal électrique d'entrée modifié.

9. La méthode (600) selon la revendication 1, dans laquelle
le canal non linéaire comporte une première partie de distorsion linéaire précédant la partie de distorsion non linéaire, et la détermination des coefficients du filtre non linéaire comprend en outre la sélection de coefficients du filtre non linéaire qui réduisent les distorsions causées par la première partie de distorsion linéaire en plus de réduire les distorsions non linéaires.

10. La méthode (600) selon la revendication 5, comprenant en outre:
initialiser du deuxième filtre linéaire et du filtre non linéaire en générant un signal électrique d'entrée modifié sous la forme d'un ensemble de signaux électriques multitons comprenant une partie présentant une première composante de fréquence et une deuxième composante de fréquence;
transmettre du signal électrique d'entrée modifié à travers le canal non linéaire afin de générer le signal électrique propagé d'origine, ledit signal électrique propagé d'origine comprenant une ou plusieurs composantes de distorsion d'intermodulation de la première composante de fréquence et de la deuxième composante de fréquence qui sont générées par la transmission du signal électrique multitonal à travers le canal non linéaire;
dans lequel la détermination des coefficients du filtre non linéaire et du deuxième filtre linéaire est effectuée à l'aide d'une synchronisation qui synchronise dans le temps l'ensemble de signaux électriques multitonalités.
